(19) Europäisches Patentamt
European Patent Office
Office européen des brevets

(11) **EP 3 182 081 B1**

(12) **FASCICULE DE BREVET EUROPEEN**

(45) Date de publication et mention
de la délivrance du brevet:
**14.03.2018 Bulletin 2018/11**

(51) Int Cl.:
***G01J 5/04*** *(2006.01)*   ***G01J 5/02*** *(2006.01)*
***G01J 5/20*** *(2006.01)*

(21) Numéro de dépôt: **16200861.9**

(22) Date de dépôt: **28.11.2016**

(54) **DISPOSITIF DE DETECTION A MEMBRANES BOLOMETRIQUES SUSPENDUES A FORT RENDEMENT D'ABSORPTION ET RAPPORT SIGNAL SUR BRUIT**

DETEKTIONSVORRICHTUNG MIT HÄNGENDEN BOLOMETRISCHEN MEMBRANEN MIT STARKER ABSORPTIONSLEISTUNG UND STARKEM SIGNAL-RAUSCH-VERHÄLTNIS

DETECTION DEVICE WITH SUSPENDED BOLOMETRIC MEMBRANES WITH HIGH ABSORPTION EFFICIENCY AND SIGNAL-TO-NOISE RATIO

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.12.2015 FR 1562347**

(43) Date de publication de la demande:
**21.06.2017 Bulletin 2017/25**

(73) Titulaire: **ULIS**
**38113 Veurey Voroize (FR)**

(72) Inventeurs:
• **CORTIAL, Sébastien**
**38360 SASSENAGE (FR)**
• **VILAIN, Michel**
**38450 SAINT GEORGES DE COMMIERS (FR)**

(74) Mandataire: **Cabinet Laurent & Charras**
**Le Contemporain**
**50 Chemin de la Bruyère**
**69574 Dardilly Cedex (FR)**

(56) Documents cités:
**EP-A1- 2 894 444   EP-A1- 2 908 109**
**JP-A- 2000 346 704   US-A- 5 288 649**
**US-A1- 2006 060 784   US-A1- 2009 140 148**

**Description**

D**OMAINE DE L'INVENTION**

L'invention a trait au domaine des détecteurs de rayonnement électromagnétique, en particulier de détecteurs à micro bolomètres destinés à la détection de rayonnements, typiquement dans le domaine « thermique », autrement dit infrarouge.

**ETAT DE LA TECHNIQUE**

Les détecteurs de rayonnement infra-rouge (« IR ») sont typiquement fabriqués sous la forme de juxtaposition bidimensionnelle (e.g. matricielle) d'un ensemble de micro-détecteurs élémentaires disposés en surface d'un substrat support, chaque micro-détecteur étant destiné à former un point d'image. Chaque micro-détecteur comprend une membrane suspendue au-dessus du substrat et connectée électriquement à ce dernier au moyen de longues poutres étroites (ou « bras ») encastrées sur des piliers électriquement conducteurs. L'ensemble est placé dans une enceinte hermétique, par exemple un boitier sous pression très réduite, de manière à supprimer la conductance thermique du gaz environnant.
Chaque membrane s'échauffe en absorbant le rayonnement incident en provenance de la scène thermique observée, transmis et focalisé par une optique adéquate au niveau du plan focal sur lequel sont disposées les membranes. Cette membrane comporte notamment une couche d'un matériau « transducteur » dont une propriété électrique, la résistivité dans le cas des micro bolomètres, évolue fortement lorsque la température change, générant par exemple une variation de courant sous polarisation en tension constante, c'est-à-dire un signal électrique, proportionnelle au flux de rayonnement incident.
Les procédés de fabrication classiques de détecteurs de ce type comprennent des étapes réalisées directement à la surface d'un substrat comportant une pluralité de circuits électroniques ou « circuits de lecture » ou « ROIC » en terminologie anglo-saxonne (acronyme de « *Read Out Integrated Circuit* »), de manière dite « monolithique ». Ce terme désigne une séquence continue d'opérations sur le même substrat, à la suite du processus de fabrication du circuit intégré, habituellement en silicium. Les étapes de fabrication des micro-détecteurs bolométriques sont en général analogues aux techniques usuelles de fabrication collective de l'industrie microélectronique, concernant habituellement quelques dizaines à quelques centaines de détecteurs matriciels disposés sur un même substrat.
Au cours de ces étapes de fabrication, les organes mettant en oeuvre les fonctions bolométriques d'absorption optique, de transduction optique-thermique et de résistance thermique, sont formés à la surface d'une couche dite « sacrificielle », en ce sens que cette couche, simplement destinée à former une base de construction, est éliminée en fin de processus par un procédé adéquat qui n'agresse pas les autres constituants du détecteur, et notamment les organes formés sur celle-ci. Typiquement, il est mis en oeuvre une couche de polyimide, couche qui est en final éliminée par combustion dans un plasma d'oxygène. Alternativement, la couche sacrificielle est une couche d'oxyde de silicium (génériquement désignée par « *SiO* ») éliminée en final par attaque fluorhydrique en phase vapeur (*HFv*). Suite à l'élimination de la couche sacrificielle, les membranes bolométriques restent suspendues au-dessus du substrat, sans autre contact ou attache que leurs bras de maintien encastrés dans les piliers.
La méthode de fabrication la plus répandue pour réaliser les membranes suspendues est dite « above IC » ou « MEMS-on-top ». Selon cette méthode, les micro-détecteurs sont construits directement à la surface du substrat comprenant les circuits de lecture, grâce à des procédés spécifiques. Notamment, la couche sacrificielle est de nature organique - en général du polyimide - et le matériau transducteur le plus souvent un oxyde à caractère semi-conducteur (*VOx, NiOx*) ou du silicium amorphe (*a-Si*). Traditionnellement, pour la détection habituelle en infrarouge « lointain » (LWIR), il est également formé une lame quart-d'onde entre la membrane absorbante et un réflecteur disposé en surface du substrat, de manière à former un maximum d'absorption du détecteur au voisinage de 10 micromètres. Ainsi, afin de connecter et maintenir la membrane à distance adaptée du réflecteur, pour former ladite lame quart-d'onde dans le vide, des piliers électriques à haut rapport d'aspect, habituellement plutôt complexes et d'encombrement non négligeable doivent être réalisés au travers d'une épaisse couche temporaire (sacrificielle) de polyimide de l'ordre de 2 à 2,5 micromètres.
Les couches diélectriques ou résistives qui constituent le « squelette » de la membrane, sont quant à elles réalisées classiquement en oxyde de silicium (*SiO*) ou nitrure de silicium (noté génériquement *SiN*), ou encore directement en silicium amorphe semi-conducteur selon par exemple la demande de brevet américain US 5 912 464. Ces matériaux peuvent être déposés à relativement basse température et sont inertes vis-à-vis du procédé d'élimination de la couche sacrificielle organique sous plasma oxygéné. Ce processus de fabrication « above IC » est constitué typiquement d'une dizaine de « niveaux » photo-lithographiques, c'est-à-dire selon un processus relativement complexe et couteux.
Plus récemment, il a été proposé un nouveau type de fabrication des membranes qui consiste à intégrer les micro-bolomètres dans les couches dite « back-end » (ou « BEOL » acronyme anglo-saxon pour « *Back End Of Line* »), à la manière des organes réalisant les fonctions MEMS en général. Cet acronyme désigne les étapes de fabrication de l'ensemble des interconnexions métalliques à relativement basse température, caractéristiques de la fin de processus de fabrication microélectroniques standards. Le but de cette approche dite « MEMS-in-CMOS » est d'exploiter certaines dispositions du BEOL, matures sur le plan industriel, pour intégrer une partie des organes du micro bolomètre. En particulier, les vias métallisés d'interconnexion verticale entre niveaux de métal successifs BEOL, obtenus par exemple selon le procédé « damascene » constituent avantageusement les piliers des micro-détecteurs. Par ailleurs, les « IMD » (acronyme de *« Inter-Metal-Dielectrics »*), en particulier en *SiO,* matériau standard en microélectronique, peuvent être avantageusement mis en oeuvre comme couches sacrificielles de construction des structures membranaires. Dans ce type d'intégration, les derniers niveaux photo-lithographiques pour la fabrication du circuit de lecture sont également utilisés pour réaliser directement les piliers soutenant les membranes. Il est donc économisé quelques niveaux lithographiques parmi la série des niveaux nécessaires à la fabrication des micro bolomètres, d'où une économie significative sur les couts de fabrication. Toutefois, l'élimination de la couche sacrificielle en *SiO* de la fabrication « MEMS-in-CMOS » n'est dans ce cas faisable qu'au moyen d'acide fluorhydrique en phase vapeur (*HFv).* En conséquence, tous les matériaux constituant les micro bolomètres doivent impérativement être inertes vis-à-vis de ce procédé chimiquement très agressif.

Une telle approche « MEMS-in-CMOS », appliquée au cas des micro bolomètres, a été décrite dans le document US 2014/319350 qui détaille l'intégration dans l'empilement CMOS d'une couche sacrificielle *SiO* et d'une couche barrière permettant de contenir la gravure *HFv,* ainsi que la réalisation des « piliers » des micro bolomètres en exploitant la dernière structure de connexion inter-niveaux métalliques (vias métallisés) standards de l'assemblage CMOS. Ce document décrit plus particulièrement une construction de micro bolomètres à base de silicium amorphe qui exploite l'enseignement du document US 5 912 464 pour ce qui concerne l'architecture de la membrane. Il est ainsi obtenu une structure compatible avec la gravure *HFv* et réalisée au moyen de cinq niveaux photo-lithographiques seulement, ce qui apporte un gain très significatif par rapport au processus nettement plus complexe de l'état de l'art.

Si la technique « MEMS-in-CMOS » permet de simplifier la fabrication, elle souffre cependant de plusieurs limitations qui pénalisent la performance des micro bolomètres ainsi construits.

En particulier, l'architecture proposée selon cette technique impose un partage de l'espace disponible entre des zones métallisées destinées en particulier à absorber le rayonnement incident, et des zones uniquement occupées par le matériau transducteur (silicium amorphe). La fraction de la surface occupée par le métal conditionne la fonction de transduction optique - thermique (le rendement d'absorption optique $\varepsilon$ de la membrane), tandis que la fraction de surface restante est consacrée à la fonction de transduction thermique - électrique dans le matériau transducteur. Cette limitation du volume de matériau impliqué dans la conduction électrique (par rapport au volume total de silicium amorphe présent dans la structure) engendre une réduction du nombre de porteurs de charges *N* mis en jeu dans la conduction. Il en résulte nécessairement une hausse substantielle du bruit basse fréquence (« *B1/f* ») conformément à la relation de Hooge, qui pénalise le ratio Signal/Bruit (« *SNR* ») du détecteur.

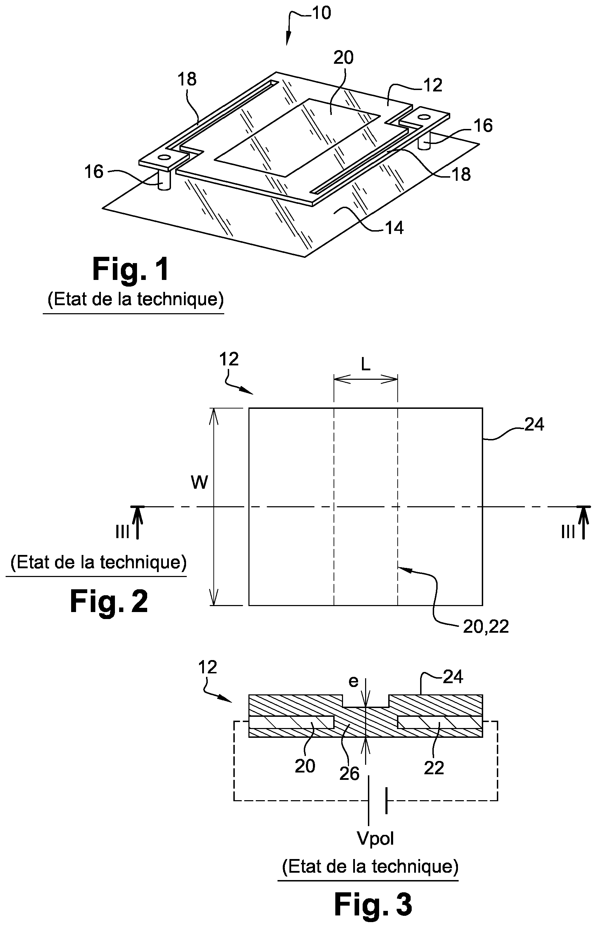

Pour mieux comprendre cette problématique, il est fait référence aux figures 1 à 3, illustrant un micro-détecteur bolométrique résistif élémentaire **10** (ou « micro bolomètre ») de l'état de la technique pour la détection infrarouge. Le bolomètre **10** comporte une fine membrane **12** absorbant le rayonnement incident, suspendue au-dessus d'un substrat - support **14** par l'intermédiaire de deux piliers d'ancrage conducteurs **16** auxquels elle est fixée par deux bras de maintien et d'isolation thermique **18.** Dans l'exemple illustré, la membrane **12** comprend deux éléments métalliques **20, 22** ayant une fonction d'absorbeur de rayonnement IR et d'électrodes de polarisation, et une couche de silicium amorphe **24** recouvrant chacune des deux électrodes **12, 14** et emplissant l'espace **18** séparant celles-ci. La couche **24** a une fonction de transduction de l'échauffement provoqué par l'absorption du rayonnement par les électrodes **20, 22** en une variation de résistance électrique. Dans cette structure, le matériau transducteur est donc constitué uniquement de silicium amorphe, qui a l'avantage d'être inerte au processus de libération de la couche sacrificielle à base d'acide fluorhydrique en phase vapeur.

La réponse $\mathcal{R}$ (V/K) d'un micro bolomètre de résistance électrique *Rb* polarisé sous tension constante *Vpol* exprime la variation de signal en sortie $\partial$S en relation avec une variation de température de scène $\partial\theta_{sc}$ selon la relation générale :

$$\mathcal{R} = \frac{\partial S}{\partial \theta_{sc}} \propto \frac{Vpol}{Rb} A * \varepsilon * TCR * R_{th} * \frac{\partial \Theta(\theta_{sc})}{\partial \theta_{sc}} \quad (1)$$

où :

- *A* est l'aire totale du point élémentaire sensible (pixel détecteur),
- $\varepsilon$ est l'efficacité globale d'absorption optique du bolomètre,
- *TCR* est le coefficient de variation de la résistance du bolomètre en fonction de la température de la membrane,
- $R_{th}$ est la résistance thermique entre la membrane et le substrat (c'est-à-dire des bras de maintien), et

- $\Theta(\theta_{sc})$ est le flux radiatif émis par la scène à la température $\theta_{sc}$.

Comme évoqué auparavant, l'efficacité d'absorption optique $\varepsilon$ est liée à la fraction de la surface de chaque membrane, occupée par le métal déposé à cette fin.

La résistance électrique d'un micro-détecteur *Rb* s'exprime quant à elle en fonction de la résistivité $\rho$ du matériau transducteur par exemple selon la relation :

$$Rb = \rho * \frac{L}{W*e} \quad (2)$$

où *L, W* et *e* sont respectivement la longueur, la largeur et l'épaisseur du volume de matériau transducteur (supposé, ou ramené à une forme parallélépipédique) parcouru par le courant électrique.

Dans l'exemple de membrane de la figure 1, ces dimensions sont sensiblement celles de la zone séparant les électrodes **20, 22,** correspondant par exemple en une interruption physique (ou rainure) pratiquée dans une couche initialement continue de métal pour réaliser les électrodes (qui sont dans cet exemple typique qualifiées de « coplanaires » car disposées au même niveau).

La combinaison des relations (1) et (2) permet donc de préciser la réponse d'un micro-détecteur en fonction des paramètres dimensionnels de la résistance *Rb* mise enjeu.

La puissance de bruit en courant d'une résistance polarisée sous une tension *Vpol* s'exprime par la somme quadratique du bruit basse fréquence dit « en 1/f » ($I_{b1/f}$) et d'une composante indépendante de la fréquence dite « bruit blanc » ($I_{bb}$). Le bruit ultime lié aux fluctuations thermiques peut être négligé devant ces contributeurs de premier ordre.

La puissance de bruit $I_{b1/f}^2$ varie pour sa part selon l'inverse du nombre *N* de porteurs de charge contenus dans le volume concerné par les lignes de courant, selon la relation de Hooge :

$$I_{b1/f}^2 = \frac{\alpha_H}{N} * \left(\frac{Vpol}{Rb}\right)^2 * ln(BPCL) \quad (3)$$

où $\alpha_H$ est le « paramètre de Hooge » et « *BPCL* » est la bande passante en fréquence du circuit de lecture. Chaque matériau est caractérisé par un ratio de référence $\frac{\alpha_H}{n}$, dans n lequel *n* est la densité volumique de porteurs de charge ; ce ratio dépend par ailleurs de la température. Ainsi, pour une résistance *Rb* de dimensions connues, le ratio $\frac{\alpha_H}{N}$ réel de l'élément considéré est calculé simplement à partir des paramètres dimensionnels *W, L, e* selon la relation :

$$\frac{\alpha_H}{N} = \frac{\alpha_H}{n} * \left(\frac{1}{W*L*e}\right) \quad (4)$$

La puissance de bruit blanc $I_{bb}^2$ ne dépend que de la température et de la résistance de l'élément considéré selon la relation :

$$I_{bb}^2 = \frac{4*k*T}{Rb} * (BPCL) \quad (5)$$

où *k* désigne la constante de Boltzmann et *T* la température.

Un micro-détecteur doté d'une portion de matériau transducteur caractérisée par son ratio $\frac{\alpha_H}{N}$ et sa résistance *Rb*, défini à partir des dimensions connues *W, L* et *e*, présente ainsi un bruit total $I_b$ qui s'exprime selon la relation :

$$I_b = \sqrt{\left[\frac{4*k*T}{Rb} * (BPCL) + \frac{\alpha_H}{N} * \left(\frac{Vpol}{Rb}\right)^2 * ln(BPCL)\right]} \quad (6)$$

Le ratio signal / bruit du micro-détecteur *(SNR)* se calcule par le ratio de la réponse (1) sur le bruit (6) en prenant en compte les éléments définis par le circuit de lecture *(Vpol, BPCL)* et les paramètres dimensionnels de la résistance de chaque micro-détecteur *(W, L,* e) qui permettent d'exprimer la résistance bolométrique *Rb* et le nombre de porteur de charges *N.* Le ratio *SNR* s'exprime ainsi selon la relation :

$$SNR \propto \left( \frac{\mathcal{R}}{I_b} \right) \qquad (7)$$

Afin d'exemplifier de manière simplifiée, mais représentative, un pixel de très petites dimensions tel qu'il est aujourd'hui utile, voire nécessaire de proposer industriellement, considérons le cas d'un détecteur bolométrique élémentaire dont la surface est de 12 x 12$\mu$m$^2$.

Pour définir le partage de cette surface disponible entre une fraction métallisée **20, 22** nécessaire à l'absorption du rayonnement thermique, et une fraction **26** électriquement active destinée à la transduction thermique - électrique, il est pratique de définir une rainure de longueur (électrique) *L* gravée dans une couche métal sur toute la largeur (électrique) *W* = 12$\mu$m de cet élément. Le ratio de surface occupé par le métal est alors égal à (12-*L*)/12, tandis que les longueurs et largeur de la résistance sont respectivement *L* et *W* = 12$\mu$m. Les équations (2), (4) et (7) conduisent à la résistance bolométrique *(Rb)*, au ratio $\frac{\dot{\alpha_H}}{N}$, puis finalement au *SNR* en fonction de la grandeur de design *L.*

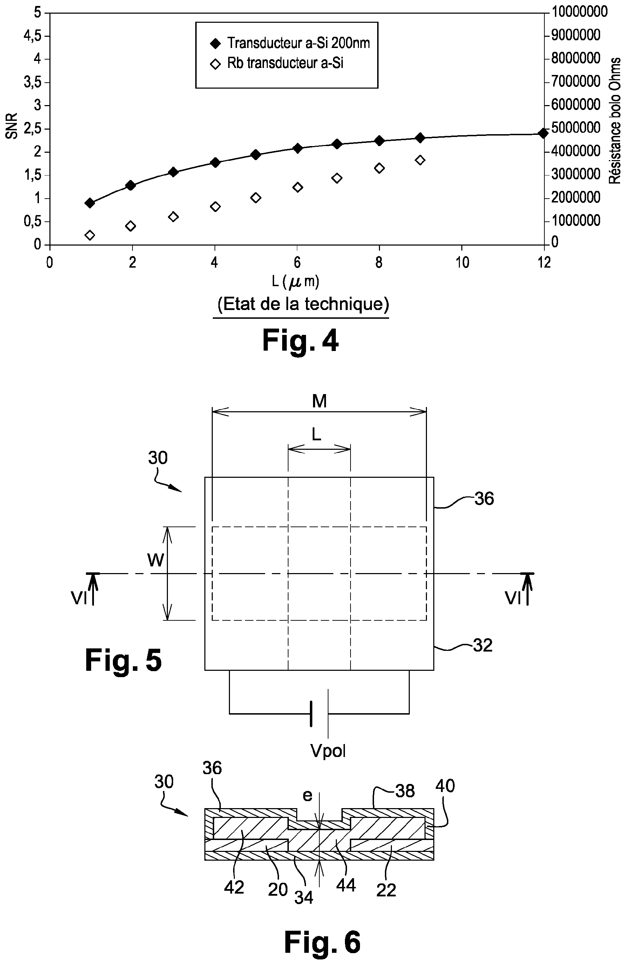

Ainsi, en négligeant pour simplifier les espaces consommés pour former les séparations inter-membranes adjacentes et les sous-structures telles que piliers, bras de maintien, et autres espaces nécessaires divers, il est considéré dans ce qui suit comme schématisé en figure 1, une aire de 12*12 $\mu$m$^2$ comportant deux parties rectangulaires métallisées séparées par une rainure de longueur *L,* qui est aussi la longueur d'un volume de transducteur en silicium amorphe de largeur *W* = 12$\mu$m, de résistivité indicative 100$\Omega$.cm, d'épaisseur typique *e* = 200 nm, et de ratio $\frac{\alpha_H}{n} = 6.7\text{E-}28 \text{ m}^3$, la résistance *Rb* et le *SNR* présentent une évolution en fonction de la distance *L* illustrée sur la figure 4.

Afin de produire un rendement $\varepsilon$ d'absorption optique optimal, il est nécessaire de fixer la longueur des zones non métallisées à des valeurs au maximum de l'ordre de 2-3$\mu$m. Cet espacement (longueur *L*) est par ailleurs nécessaire pour maintenir la résistance *Rb* du bolomètre élémentaire dans une gamme de valeurs compatible avec une mise en oeuvre adéquate du circuit de lecture dans le contexte de l'invention, en termes de polarisation *Vpol,* de temps d'intégration en lecture, et de dynamique utile (sans saturation) de l'amplificateur de sortie. Cette condition est satisfaite typiquement lorsque la résistance bolométrique *Rb* est de l'ordre de, ou inférieure, à 1 MOhm environ. Pour plus d'éclaircissement en relation avec ces éléments, on verra par exemple « *Uncooled amorphous silicon technology enhancement for 25$\mu$m pixel pitch achievement* » ; E. Mottin et al, Infrared Technology and Application XXVIII, SPIE, vol. 4820E.

Ainsi, avec une longueur *L* fixée à 2$\mu$m pour garantir un rendement d'absorption à l'état de l'art et une résistance acceptable, le *SNR* de ce micro-détecteur à base de silicium amorphe sera limité à 60% environ de sa valeur maximale correspondant aux grandes longueurs *L* (hors pertes d'absorption). Cette limitation est liée à l'augmentation du bruit basse fréquence aux faibles valeurs de *L.*

L'obtention d'un compromis acceptable entre le rendement d'absorption et le *SNR* est donc délicate, voire impossible, pour les pixels sensibles de petites dimensions réalisés selon cet assemblage simplifié, particulièrement pour des pas inférieurs à 20$\mu$m. L'utilisation de matériaux transducteurs peu bruyants à basse fréquence, tels que les oxydes métalliques semi-conducteurs *(VOx, TiOx, NiOx,* par exemple - la dénomination générique « *MOx* » sera employée par la suite), permettrait en principe de repousser cette limitation. Cependant, la mise en oeuvre de ces matériaux dans l'empilement de l'état de la technique n'est pas possible car ces matériaux seraient rapidement éliminés ou au moins fortement dégradés sous l'effet de la chimie de libération très agressive *HFv.* D'autres exemples de l'état de la technique sont fournis par les documents EP2894444, EP2908109, JP2000346704, US5288649, US20060060784 et US20090140148.

Il existe donc un besoin, au moins dans le cadre d'assemblages micro bolométriques en partie intégrés à une filière CMOS, c'est-à-dire dont la matière sacrificielle est constituée de *SiO* ou tout matériau apparenté classique en microélectronique, de disposer de dispositifs de haute performance et de leurs méthodes de fabrication compatibles avec le design de rétines de très petit pas, typiquement en dessous de 20$\mu$m.

## EXPOSE DE L'INVENTION

L'invention a ainsi pour but de proposer un détecteur à membranes bolométriques suspendues, membranes dont l'architecture permet une haute performance en termes de rendement d'absorption et de *SNR,* et dont l'architecture peut être, au besoin, fabriquée selon une technologie nécessitant l'emploi d'une chimie de libération de couche sacrificielle très agressive.

A cet effet, l'invention a pour objet un dispositif de détection bolométrique comprenant :

- un substrat comprenant un circuit de lecture ;
- une matrice de détecteurs élémentaires comprenant chacun une membrane suspendue au-dessus du substrat et raccordée au circuit de lecture par au moins deux conducteurs électriques, ladite membrane comprenant deux électrodes électriquement conductrices respectivement raccordées aux deux conducteurs électriques, et un volume de matériau transducteur raccordant électriquement les deux électrodes, dans lequel le circuit de lecture est configuré pour appliquer un stimulus électrique entre les deux électrodes de la membrane et pour former un signal électrique en réponse à ladite application, dispositif dans lequel ledit volume comporte:

- un volume d'un premier matériau transducteur raccordant électriquement les deux électrodes de la membrane et formant des parois d'une enceinte fermée dans laquelle chacune des électrodes est logée au moins partiellement ; et
- un volume d'un second matériau transducteur, raccordant électriquement les deux électrodes et logé dans l'enceinte, la résistivité électrique du second matériau étant inférieure à la résistivité électrique du premier matériau.

Par « transducteur », il est entendu un matériau dont la résistivité est comprise entre 0,1 et $10^4$ Ohm.cm et présentant un coefficient thermique de résistance *TCR* négatif. L'invention a également pour objet un procédé de fabrication d'un dispositif de détection bolométrique, comprenant :

- la fabrication d'un substrat comprenant un circuit de lecture ;
- le dépôt sur le substrat d'une couche sacrificielle ;
- la fabrication, sur la couche sacrificielle, d'une matrice de membranes, chacune raccordée au circuit de lecture par au moins deux conducteurs électriques, ladite membrane comprenant deux électrodes électriquement conductrices respectivement raccordées aux deux conducteurs électriques, et un volume de matériau transducteur raccordant électriquement les deux électrodes ;
- une fois les membranes fabriquées, le retrait de la couche sacrificielle, procédé dans lequel la fabrication du volume transducteur comporte :
- le dépôt d'une couche inférieure d'un premier matériau transducteur sur la couche sacrificielle ;
- la formation, sur la dite couche du premier matériau, des deux électrodes de la membrane ;
- le dépôt sur, et entre les électrodes, d'une couche de second matériau transducteur ; et
- l'encapsulation de la couche de second matériau transducteur par une couche supérieure du premier matériau de manière à également couvrir partiellement les deux électrodes.

En outre:

- la résistivité électrique du second matériau est inférieure à la résistivité électrique du premier matériau ;
- le premier matériau est inerte au retrait de la couche sacrificielle.

En d'autres termes, le matériau transducteur est réalisé d'une « coque » et d'un « coeur » électriquement en parallèle vis-à-vis des électrodes formant organe d'absorption du rayonnement, avec le coeur constitué d'un matériau de plus faible résistivité que la coque, particulièrement au moins 5 fois plus faible, et typiquement 10 à 20 fois plus faible.

Particulièrement encore, la coque est constituée d'un matériau de résistivité supérieure à 10 Ohm.cm.

Ce type d'architecture permet une composante de bruit basse fréquence réduite ($I_{b1/f}$), essentiellement mise en oeuvre par le coeur en raison de la résistivité du coeur, tout en permettant grâce à la coque un choix de matériau approprié en fonction de la technologie de fabrication, par exemple une coque inerte à l'attaque chimique de libération de la couche sacrificielle dans le cadre d'une technologie MEMS-in-CMOS.

Selon un mode de réalisation, les deux électrodes sont coplanaires et séparées uniquement par une rainure. En variante, les deux électrodes appartiennent à une série d'au moins trois zones électriquement conductrices, coplanaires, et séparées les unes des autres par des rainures parallèles disposées entre les deux électrodes.

Selon un mode de réalisation, la membrane comporte une couche continue d'isolant électrique s'étendant entre les électrodes et recouvrant partiellement chacune d'entre elles.

Selon un mode de réalisation, la résistivité électrique du second matériau est au moins cinq fois plus faible que la résistivité électrique du premier matériau, et de préférence dix fois à vingt fois plus faible.

Selon un mode de réalisation, le premier matériau a une résistivité électrique supérieure à 10 Ohm.cm, et de préférence une résistivité inférieure à $10^4$ Ohm.cm.

Selon un mode de réalisation, le premier matériau est du silicium amorphe, un alliage amorphe de silicium et de germanium de formule $Si_xGe_{(1-x)}$, ou un alliage amorphe de silicium et carbone de formule $a\text{-}Si_xC_{(1-x)}$, et le second matériau est un oxyde métallique.

Selon un mode de réalisation, la couche sacrificielle est retirée par une attaque d'acide fluorhydrique *HFv,* et en ce que le premier matériau est du silicium amorphe, un alliage amorphe de silicium et de germanium de formule a-$Si_xGe_{(1-x)}$, ou un alliage amorphe de silicium et carbone de formule $a$-$Si_xC_{(1-x)}$.

Selon un mode de réalisation, les deux électrodes sont formées en déposant une couche de matériau électriquement conducteur et en réalisant uniquement une rainure dans ladite couche jusqu'à la couche inférieure de premier matériau.

Selon un mode de réalisation, les deux électrodes sont formées en déposant une couche de matériau électriquement conducteur et en réalisant au moins deux rainures parallèles dans ladite couche jusqu'à la couche inférieure de premier matériau.

Selon un mode de réalisation, le procédé comprend, avant dépôt du second matériau transducteur, le dépôt d'une couche électriquement isolante s'étendant entre les électrodes et recouvrant partiellement chacune d'entre elles.

## BREVE DESCRIPTION DES FIGURES

L'invention sera mieux comprise à la lecture de la description qui va suivre, donnée uniquement à titre d'exemple, et réalisée avec les dessins annexés, dans lesquels des références identiques désignent des éléments identiques ou équivalents, et dans lesquels :

- la figure 1 est une vue schématique en perspective d'une membrane bolométrique de l'état de la technique suspendue au-dessus d'un circuit de lecture ;
- les figures 2 et 3 sont des vues schématiques de dessus et en coupe de la membrane de la figure 1 ;
- la figure 4 est un tracé des rapports signal-sur-bruit en fonction de la longueur de l'espace inter-électrodes d'une membrane de la figure 1 ;
- les figures 5 et 6 sont des vues schématiques de dessus et en coupe d'une membrane bolométrique selon un premier mode de réalisation de l'invention ;
- la figure 7 est un tracé des rapports signal-sur-bruit en fonction de la longueur de l'espace inter-électrodes d'une membrane de la figure 1 et d'une membrane selon le premier mode de réalisation de l'invention ;
- la figure 8 est un tracé de rapports signal-sur-bruit en fonction de l'épaisseur de silicium amorphe dans une membrane selon l'invention ;
- les figures 9 et 10 sont des vues schématiques de dessus et en coupe d'une membrane bolométrique selon un second mode de réalisation de l'invention ;
- la figure 11 est un tracé des rapports signal-sur-bruit en fonction de la longueur de l'espace inter-électrodes d'une membrane de la figure 1 et d'une membrane selon les premier et second modes de réalisation de l'invention ;
- les figures 12 et 13 sont des vues schématiques de dessus et en coupe d'une membrane bolométrique selon un troisième mode de réalisation de l'invention ;
- les figures 14 et 15 sont des vues schématiques de dessus et en coupe d'une membrane bolométrique selon un troisième mode de réalisation de l'invention ; et
- les figures 16 et 17 sont des vues schématiques en coupe illustrant un procédé de fabrication d'une membrane selon l'invention.

## DESCRIPTION DETAILLEE DE L'INVENTION

### PREMIER MODE DE REALISATION

En se référant aux figures 5 et 6, une membrane **30** de micro-détecteur bolométrique selon l'invention comporte :

- une coque d'encapsulation **32,** avantageusement en silicium amorphe, comportant une couche inférieure ou « basale » **34,** et un capot supérieur **36** formé d'une couche supérieure **38** et de parois latérales **40,** définissant ensemble un volume interne **42** de largeur *W,* de longueur *M* et de hauteur e ;
- deux électrodes conductrices **20, 22,** par exemple métalliques, reposant sur la couche inférieure **34** et recouvrant la totalité de cette dernière, sauf en ce qui concerne une interruption (ou rainure) de longueur (électrique) *L* les séparant physiquement. Le capot supérieur **36** repose par ailleurs sur chacune des électrodes **20, 22,** définissant donc un premier canal de conduction entre celles-ci ainsi qu'une cavité hermétique aux procédés chimiques agressifs pour le volume interne **42** ;
- un coeur **44** remplissant entièrement le volume interne **42,** et reposant en conséquence sur chacune des électrodes **20, 22,** et définissant donc un deuxième canal de conduction entre ces dernières, de largeur *W* et d'épaisseur *e,* en parallèle du premier canal de conduction. Le coeur **44** est constitué d'un matériau de résistivité plus faible que le matériau de la coque, au moins 5 fois plus faible, et typiquement 10 à 20 fois plus faible. Notamment, le coeur **44** est constitué d'un oxyde métallique à coefficient *TCR* négatif, par exemple du *VOx* et/ou du *TiOx* et/ou du *NiOx*, définissant un second canal de conduction doté d'un faible coefficient de bruit basse fréquence.

Dans cette configuration, le courant circule entre les deux pôles métalliques **20, 22,** dans l'oxyde métallique sur la largeur *W* et dans le silicium amorphe sur sensiblement toute la largeur du pixel (e.g. 12μm). Selon l'exemple considéré ici, les deux couches inférieure **34** et supérieure **38** de silicium amorphe, sont d'épaisseur égale, soit 20 nanomètres. La largeur *W* et l'épaisseur e du *MOx* sont des variables d'ajustement de la résistance *Rb* du pixel. Elles ont été fixées ici à 6 μm et 40 nm, respectivement, afin d'obtenir une résistance *Rb* proche de 800 KΩ pour *L* = 2 μm.

Les deux contributions de courant, circulant dans les deux matériaux transducteurs, s'ajoutent pour le calcul de la réponse *R,* et se somment de manière quadratique pour l'estimation du bruit. Il est ainsi obtenu pour ce dernier :

$$I_b = \sqrt{I_{b(a-Si)}^2 + I_{b(MOx)}^2} \qquad (8)$$

Le ratio *SNR* peut ainsi être calculé pour le cas du pixel schématisé en figures 5 et 6, en fonction de la longueur *L* du canal de conduction, par exemple de manière simplifiée en admettant que le coefficient *TCR* est comparable pour les deux matériaux transducteurs.

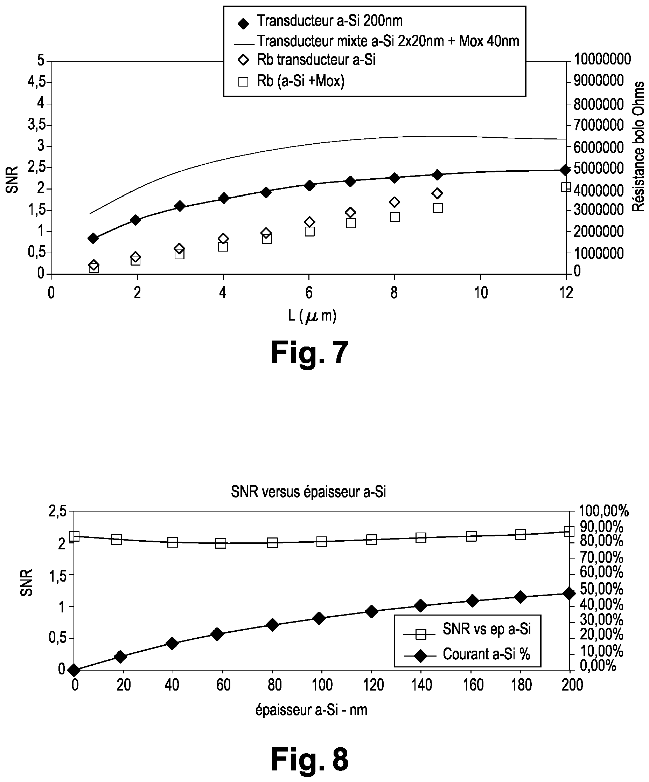

Le graphique de la figure 7 montre que l'insertion d'une couche de transducteur oxyde métallique dix fois moins résistif que le silicium amorphe et générant peu de bruit basse fréquence pour une même résistance *Rb,* permet de compenser en grande partie la dégradation du *SNR* occasionnée par la réduction de *L* autour de 2 μm. Il a été admis pour la construction de tous les graphiques un rapport $\alpha_H/N$ = 2.6 E-29 m$^3$ pour le second matériau transducteur, valeur considérée représentative de la technique connue.

Ainsi, le *SNR* obtenu pour *L*=2μm dans la configuration de l'invention (2 unités arbitraires, ou « u.a. », environ) est équivalent à la valeur accessible pour *L*=6μm constitué uniquement d'un transducteur *a-Si* de 200nm d'épaisseur selon les assemblages décrit dans le document US 5 912 464.

Le courant circulant dans le silicium amorphe, qui représente 17% du courant total dans cet exemple, contribue à la réponse *R* grâce à son *TCR* équivalent à celui du *MOx* (relation 1), et ne pèse que marginalement sur le bruit global (relation 6). L'exploitation élargie des relations indiquées montre que la proportion du courant passant par le chemin silicium amorphe peut varier - en relation avec l'épaisseur du silicium amorphe - dans une très large gamme sans que cela n'ait d'impact significatif sur le *SNR,* comme le montre la figure 8.

SECOND MODE DE REALISATION

Si dans le mode de réalisation venant d'être décrit, l'introduction de l'oxyde transducteur *MOx* a permis un gain important sur le *SNR,* le bruit basse fréquence $I_{b1/f}$ reste malgré tout dominant à *L*=2μm, et continue donc de limiter le *SNR* du micro-détecteur.

Afin de réduire davantage ce bruit dominant lié au faible volume de matériau traversé par le courant à travers le paramètre *N,* selon un second mode de réalisation, il est défini au moins deux interruptions ou rainures parallèles et identiques, par exemple chacune de longueur *L*. La longueur effective du canal de conduction devient ainsi *P\*L*, où *P* est le nombre de rainures. Ainsi, le volume de matériau actif dans la conduction se trouve doublé pour *P* = 2, tandis que la fraction de surface métallisée correspondant aux électrodes, optiquement absorbante mais qui définit des surfaces équipotentielles inactives en termes de transduction passe de 83% à 67%. La perte engendrée sur l'absorption $\varepsilon$ peut être évaluée de l'ordre de à 10 à 15%, soit plus faible que la perte de surface, grâce à l'étroitesse des rainures en regard de la longueur d'onde du rayonnement, soit 10μm typiquement pour la détection en *LWIR.*

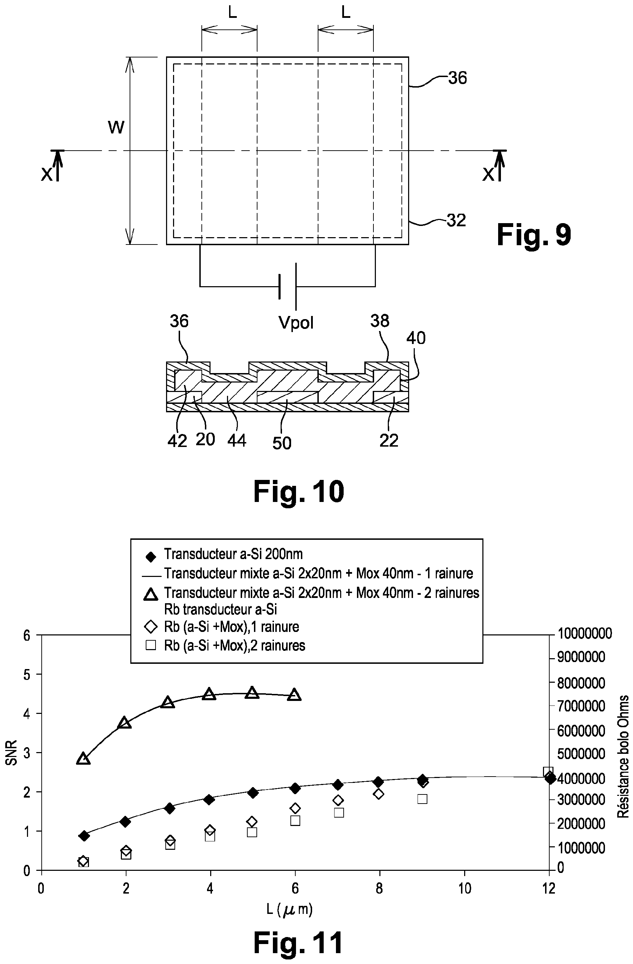

En reprenant les relations exposées pour la membrane à une rainure (fig.5 et 6), le calcul du *SNR* peut être réalisé pour une membrane sensible comportant deux rainures, définissant ainsi deux électrodes **20, 22** intercalant une zone métallique **50** (fig.9 et 10), en considérant que la longueur effective de la résistance est égale ici à 2\**L*. La grandeur *L* physique (e.g de chaque rainure) dans ce cas ne peut être balayée que jusqu'à 6 μm, au-delà de laquelle l'intégralité du pixel serait dé-métallisée (avec disparition des contacts et donc de la résistance bolométrique).

L'empilement de couches reste celui de l'exemple précédent, soit deux couches *a-Si* à 100 Ω.cm (couche basale et d'encapsulation) de 20 nm chacune, une couche d'oxyde *MOx* à 10 Ω.cm et d'épaisseur 40 nm. Seule la largeur *W* du canal *MOx* a été élargie dans ce cas à 12 μm afin de conserver (avec deux rainures) une résistance *Rb* proche de celle du pixel ne comportant qu'une rainure avec *W* = 6 μm.

Le graphique de la figure 11 montre qu'avec deux rainures de largeur *L* = 2 μm, le *SNR* se trouve quasiment doublé par rapport au cas comportant une seule rainure (3,8 vs 2,0 u.a.). Ce gain peut être associé à la réduction du bruit basse fréquence découlant du doublement du volume de matériau actif, et donc du nombre de porteurs *N* impliqués.

La dégradation de l'absorption $\varepsilon$ liée à l'ajout d'une deuxième rainure, estimée à 10% environ, est donc très largement surcompensée par l'augmentation du *SNR.*

TROISIEME MODE DE REALISATION

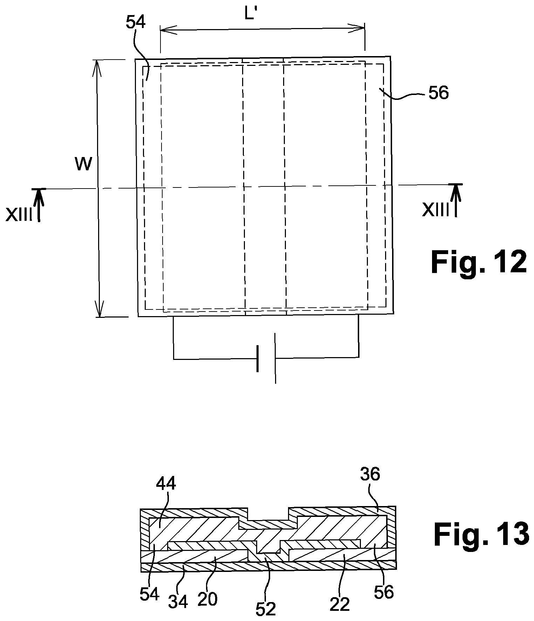

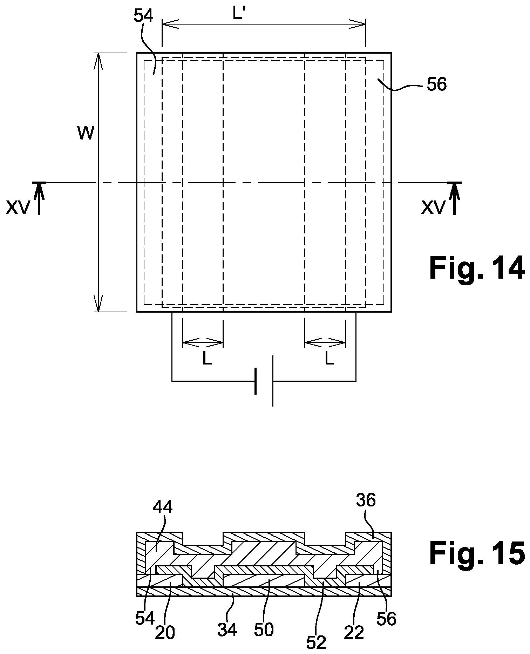

Le troisième mode de réalisation de l'invention, illustré aux figures 12 à 15, diffère des modes de réalisation décrits ci-dessus par l'insertion d'une couche d'isolant électrique, par exemple de diélectrique. Notamment, cette couche **52** est insérée entre les éléments métalliques **20, 22** (figures 12 et 13 correspondant au premier mode de réalisation complété) ou **20, 22, 50** (figures 14 et 15 correspondant au second mode de réalisation) et le transducteur *MOx* **44,** sur toute leur emprise commune, sauf selon deux bandes **54, 56** parallèles à la ou aux rainures de longueur *L* et situées le long et à proximité de deux arêtes opposées de la membrane. Ainsi, la longueur effective *L'*, c'est-à-dire la longueur électrique totale du cheminement des lignes de courant entre les deux terminaux électriques du canal de conduction dans le second transducteur *MOx* **44** peut être augmentée de telle façon que *L'* » L, indépendamment de l'absorption optique $\varepsilon$. L'augmentation consécutive du volume de *MOx* - et donc du nombre de porteurs de charge *N* - a pour effet une baisse du bruit *1/f* généré dans cette couche.

Par exemple, en considérant une membrane telle qu'illustrée aux figures 12 et 13 à rainure unique, en fixant *L'* = 8 $\mu$m et comportant une rainure de longueur *L* = 2 $\mu$m dans la couche métallique, afin de respecter le critère imposé dans les modes de réalisation précédents sur la résistance *Rb,* l'épaisseur de la couche *MOx* peut être doublée dans ce cas afin de compenser l'augmentation de la longueur *L'* du canal de conduction dans ce matériau. La couche d'oxyde transducteur à (par exemple) 10 $\Omega$.cm sera donc ici d'une épaisseur de 80 nm et définie sur une largeur *W* = 12 $\mu$m, ce qui conduit à une résistance *Rb* proche de 800 K.$\Omega$ comparable aux modes précédents.

Dans le troisième mode de réalisation, une première partie du courant parcourt le silicium de la couche basale **34** sur une longueur *L* si le pixel ne comporte qu'une seule rainure (cas a/ des figures 12 et 13), ou 2*L* si l'on a positionné deux rainures (cas b/) des figures 14 et 15). Une autre partie du courant parcourt la couche supérieure **36** d'encapsulation sur une longueur *L'* plus élevée, cette autre partie du courant est ainsi proportionnellement plus faible.

En appliquant les équations (1) à (8) sur les différentes contributions de courant prenant place dans ce mode de réalisation, et en utilisant les paramètres listés ci-dessus (*MOx* **44** avec *W* = 12$\mu$m, *e* = 80 nm à 10 $\Omega$.cm et $\alpha_H/n$ = 2,6E-29 m$^3$, inséré entre deux couches *a-Si* de 20 nm d'épaisseur chacune à 100 $\Omega$.cm), il en résulte une estimation de *SNR* du tableau ci-dessous pour les configurations a/ et b/ avec une et deux rainures, respectivement.

| Membrane avec couche d'isolant électrique | *Rb* (K$\Omega$) | *SNR* (u.a.) |
| --- | --- | --- |
| 1 rainure (L= 2$\mu$m) | ~741 | 3,84 |
| 2 rainures (L= 2$\mu$m) | ~775 | 5,81 |

L'insertion de la couche **52** d'isolant électrique, isolant partiellement les électrodes **20, 22** du transducteur *MOx* **44,** permet d'atteindre, avec une seule rainure *L* = 2$\mu$m, la même valeur de *SNR,* soit 3,8 u.a., que dans le second mode de réalisation (figures 9 et 10), sans la couche d'isolant **52,** mais avec deux rainures de longueur *L* = 2 $\mu$m, comme cela est visible sur les courbes de la figure 11.

Si l'on introduit une deuxième rainure de longueur 2 $\mu$m dans ce type de membrane (figures 14 et 15), le *SNR* atteint 5,8 u.a. Ce gain est lié à la réduction du bruit basse fréquence généré par la couche basale *a-Si* **34,** dominant dans le cas d'une simple rainure. Cet ultime niveau de *SNR* est obtenu en contrepartie, acceptable dans la plupart des cas, de l'ajout d'une couche diélectrique supplémentaire dans l'assemblage, et d'un niveau photo-lithographique supplémentaire.

Il convient de préciser que cette construction particulière nécessite de disposer les limites de la couche diélectrique en périphérie de pixel, en tout point inscrites à l'intérieur des limites des couches basale et d'encapsulation, de manière à ne pas offrir, le cas échéant, de point d'entrée au procédé *HFv* d'élimination de la couche sacrificielle.

On notera aussi que la limitation introduite précédemment à une, ou au plus deux rainures correspond au contexte très particulier et exemplatif de la fabrication de très petits pixels (détecteurs élémentaires) de 12 x 12$\mu$m$^2$ d'emprise. Si la technologie le permet ou pour des pixels plus étendus, la mise en oeuvre tout aussi avantageuse de l'invention peut appeler la définition de trois rainures ou plus, selon le pas du pixel. En effet, il convient de maintenir approximativement constant le ratio *W/L* pour ne pas modifier excessivement la résistance *Rb,* et de maintenir des espaces (rainures) de largeur limitée pour ne pas détériorer excessivement l'absorption optique.

De même, il est précisé la mise en oeuvre de silicium amorphe pour la formation de la coque hermétique vis-à-vis du second matériau transducteur. Il convient de préciser que le même résultat sera obtenu au moyen d'alliages de silicium et de germanium de type *a-Si$_x$Ge$_{(1-x)}$*, ou des alliages amorphes de silicium et carbone de type *a-Si$_x$C$_{(1-x)}$.*

La gamme de résistivité à considérer comme typique de l'invention tout en procurant substantiellement les avantages attachés s'étend ainsi entre 10 Ohm.cm et 10$^4$ Ohm.cm.

PROCÉDE DE FABRICATION

Il va à présent être décrit un procédé de fabrication selon un mode de réalisation de l'invention, débutant sur les étapes de fabrication de l'empilement du substrat CMOS du circuit de lecture selon les enseignements du document US 2014/319350. Le procédé selon l'invention permet la fabrication d'un détecteur bolométrique à l'aide d'un nombre limité de niveaux photo-lithographiques mais compatible avec la mise en oeuvre de tout type de matériau transducteur, avantageusement essentiellement du *MOx.*

Plus particulièrement, le procédé de fabrication selon l'invention est une technique d'assemblage des membranes compatible avec une libération d'une couche sacrificielle de type *HFv,* combinant la mise en oeuvre d'un second matériau transducteur à faible résistivité électrique de type oxyde métallique, en conjonction d'un premier matériau transducteur tel du silicium amorphe ou alliage apparenté, destinée à protéger entièrement l'oxyde métallique lors de l'opération finale d'attaque de matériau diélectrique sacrificiel. Il est ainsi obtenu une construction capable de surclasser en termes de performances (rapport Réponse / Bruit) l'état de l'art, de manière économique et compatible d'une intégration dans le flot de fabrication CMOS du ROIC support.

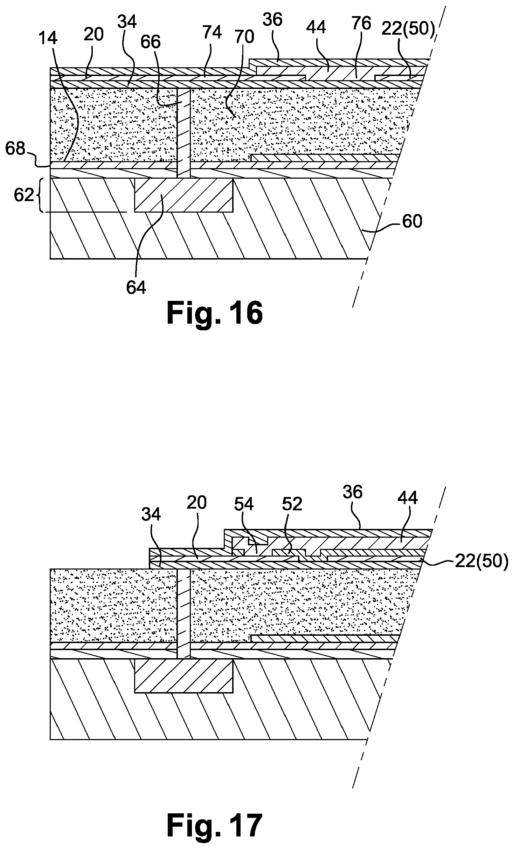

En se référant aux figures 16 et 17, le procédé selon l'invention débute par exemple de manière classique par la construction d'un circuit électronique de lecture en technologie CMOS **60** comportant un ou plusieurs niveaux **62** d'interconnexion **64** (partie « Back End » du circuit CMOS **60**) reliant notamment des blocks fonctionnels du circuit de lecture **60** entre eux, et destinés à former des liaisons d'entrées/sorties du circuit de lecture **60.** La continuité métallique entre la couche back-end du circuit **60** et chaque membrane bolométrique est par ailleurs réalisée au moyen d'un via métallisé **66** à travers une couche barrière **68,** la couche sacrificielle minérale (*SiO*) **70** et la couche basale **34** depuis le dernier métal du CMOS jusqu'à la couche métallique **74** à partir de laquelle seront formées les électrodes **20, 22** de la membrane (figure 16). L'enchainement des opérations est pour l'essentiel décrit par exemple dans le document US 2014/319350.

Le procédé se poursuit par la construction de la membrane compatible avec le procédé de libération *HFv* avec intégration d'un second matériau transducteur de plus faible résistivité, sans étapes additionnelles. En se référant à la figure 16, la fabrication de la membrane comporte :

- la gravure de la couche métallique **74** afin de définir une ou plusieurs rainures **76** de longueur *L* sur toute la largeur de la membrane et donc également deux électrodes métalliques **20, 22;**
- le dépôt du second matériau transducteur **44** à faible résistivité, par exemple et typiquement un oxyde de vanadium (de formule générique *VOx*) ou de nickel (de formule générique *NiOx*) ou de Titane (de formule générique *TiOx*) directement sur le métal des électrodes **20, 22,** de manière à former la résistance électrique *Rb* dans le plan des couches semi-conductrices, délimitée par les espaces non métallisés.
- la définition au moyen d'une gravure sèche ou humide de l'extension selon le plan de la couche **44** du second matériau transducteur, selon typiquement un simple rectangle, de dimensions plus réduites que le contour final de la membrane, c'est-à-dire en tout point de son périmètre inscrit à l'intérieur de ce (futur) contour, dudit matériau transducteur **44,** de manière sélective sur le métal et le silicium amorphe sous-jacents.
- le dépôt d'une seconde couche de silicium amorphe d'encapsulation **36** préférentiellement, mais pas nécessairement, identique en résistivité et épaisseur à la couche basale **34** ;
- la définition du contour de la membrane et des bras d'isolation thermique et gravure de l'ensemble des couches en place, c'est-à-dire les deux couches *a-Si* **34, 36,** et le métal des électrodes **20, 22.** Le périmètre de ce masque ne recoupe préférentiellement en aucun endroit le motif du second matériau transducteur **44,** de manière à ne pas produire d'exposition locale de celui-ci sur la tranche (c'est-à-dire en au moins certains points du périmètre de la membrane) de la structure. Accessoirement, cette disposition facilite la définition du procédé de gravure.

Selon cette construction, comparable au niveau des structures de soutien à la technique de référence, les bras sont uniquement formés des deux couches *a-Si* qui prennent en sandwich la couche métallique **74.** Les couches *a-Si* **34** et **36** sont ainsi d'épaisseurs comparables et préférentiellement identiques, de manière à éviter les déformations éventuelles liées à des contraintes internes différentielles.

L'empilement intégrant une couche d'isolant électrique, par exemple diélectrique, du troisième mode de réalisation est représenté sur la figure 17. Il peut être obtenu, à partir de la fabrication illustrée sur la figure en coupe 16 une fois la ou les rainures dans la couche métallique **74** réalisées, par l'application des étapes suivantes :

- le dépôt de la couche diélectrique **52** (e.g. du *SiO,* du *SiOxNy* ou équivalent), en utilisant préférentiellement les matériaux et les techniques standard BEOL de la filière CMOS ;
- la définition des ouvertures **54, 56** dans la couche diélectrique **52** pour réalisation de contacts électriques débouchant sur le métal **74.** Ces contacts sont typiquement réalisés le long de deux arêtes opposées de la membrane, et définissent les deux extrémités du parallélépipède de matériau transducteur principal **44,** déposé ensuite ;

- le dépôt du second matériau transducteur **44** à plus faible résistivité, par exemple et typiquement un oxyde de vanadium (de formule générique *VOx*) ou de nickel (de formule générique *NiOx*) ou de Titane (de formule générique *TiOx*). Le transducteur principal **44** est alors isolé en dehors des ouvertures **54, 56** du métal des électrodes, de manière à former la partie en parallèle la moins résistive de la résistance *Rb* dans le plan des couches de transducteurs, délimitée par les contacts réalisés auparavant ;
- la définition du contour du second matériau transducteur, selon par exemple un simple rectangle, ou de manière plus générale selon un polygone simple de dimensions plus réduites que l'emprise finale de la membrane, et gravure sèche ou humide dudit transducteur, par exemple sélective sur la couche diélectrique **52**. Cette gravure peut ne pas être particulièrement sélective sur la couche diélectrique **52**, auquel cas elle doit l'être par rapport à la couche métallique **74**, ce qui offre une large latitude de définition à l'homme de métier ;
- la gravure du diélectrique **52** (s'il reste à ce stade selon le procédé mis en oeuvre à l'étape précédente), par exemple et préférentiellement (de manière à utiliser avantageusement le même masque que le précédent) suivant le même contour que le second matériau transducteur, au moyen d'une chimie humide, ou de préférence sèche, sélective par rapport au métal sous-jacent **74**. Cette disposition préférentielle est destinée à supprimer le diélectrique **52** de la surface des bras de la membrane, de manière à ce qu'il n'y subsiste que les deux couches *a-Si* et le matériau métallique. Il est ainsi obtenu une résistance thermique (e.g. une réponse) maximale de la membrane suspendue ;
- le dépôt d'une seconde couche **36** de silicium amorphe d'encapsulation préférentiellement (mais pas nécessairement) équivalente en résistivité et épaisseur à la couche basale **34** ;
- la définition du contour de la membrane et des bras d'isolation thermique et gravure de l'ensemble des couches en place, c'est-à-dire les deux couches *a-Si* **34, 36**, et le métal des électrodes **20, 22**. Le périmètre de ce masque ne recoupe préférentiellement en aucun endroit le motif (l'extension) du second matériau transducteur **44** ni le diélectrique intermédiaire **52**, de manière à ne pas laisser l'une ou l'autre couche exposée localement sur la tranche de la structure. Accessoirement, cette disposition facilite la définition du procédé de gravure.

Il a été décrit des modes de réalisation particuliers dans lesquels la fonction de polarisation de la résistance *Rb* est mise en oeuvre par deux électrodes mettant également en oeuvre la fonction d'absorption.

Dans une variante, le métal utilisé pour les électrodes et le métal utilisé pour l'absorption peuvent être formés à partir de deux couches distinctes, notamment non coplanaires.

Dans une variante, le métal utilisé pour les électrodes et la couches d'absorption peut être mis en oeuvre après la définition du second matériau transducteur, la polarisation de celui-ci (la continuité électrique) étant obtenue par l'interface supérieure.

La présente invention est développée dans le cas particulier spécifiquement pertinent de mise en oeuvre comme premier matériau, pour la formation de la couche basale et de la couche d'encapsulation, en d'autres termes de la coque hermétique, de silicium amorphe de résistivité de l'ordre de $10^2$ Ohm.cm. Cependant, la mise en oeuvre de matériaux amorphes alliés avec du germanium de type *a-Si$_x$Ge$_{(1-x)}$*, ou avec du carbone de type *a-Si$_x$-C$_{(1-x)}$*, procure aisément selon dopage et composition *x* particulière des matériaux couvrant la gamme entre typiquement 10 Ohm.cm et $10^4$ Ohm.om (au-delà de laquelle on peut considérer dans ce contexte particulier ledit matériau comme quasiment « diélectrique »), sans sortir du cadre de l'invention. En effet, tous ces matériaux sont inertes vis-à-vis des procédés de gravure des couches sacrificielles *SiO* sous forme *HFv*.

**Revendications**

1. Dispositif de détection bolométrique comprenant :

 - un substrat (14) comprenant un circuit de lecture ;
 - une matrice de détecteurs élémentaires comprenant chacun une membrane (12) suspendue au-dessus du substrat (14) et raccordée au circuit de lecture par au moins deux conducteurs électriques (16, 18), ladite membrane comprenant deux électrodes électriquement conductrices (20, 22) respectivement raccordées aux deux conducteurs électriques, et un volume de matériau transducteur (24) raccordant électriquement les deux électrodes,

 dans lequel le circuit de lecture est configuré pour appliquer un stimulus électrique entre les deux électrodes (20, 22) de la membrane (12) et pour former un signal électrique en réponse à ladite application,
 ***caractérisé :***

 - **en ce que** ledit volume comporte :

■ un volume (34, 38, 40) d'un premier matériau transducteur raccordant électriquement les deux électrodes (20, 22) de la membrane (12) et formant des parois d'une enceinte fermée (42) dans laquelle chacune des électrodes (20, 22) est logée au moins partiellement ; et

■ un volume (44) d'un second matériau transducteur raccordant électriquement les deux électrodes (20, 22) et logé dans l'enceinte (42), la résistivité électrique du second matériau étant inférieure à la résistivité électrique du premier matériau ;

- et **en ce que** les deux matériaux transducteurs présentant un coefficient thermique de résistivité *TCR* négatif.

2. Dispositif de détection bolométrique selon la revendication 1, *caractérisé* **en ce que** les deux électrodes (20, 22) sont coplanaires et séparées uniquement par une rainure.

3. Dispositif de détection bolométrique selon la revendication 1, *caractérisé* **en ce que** les deux électrodes (20, 22) appartiennent à une série d'au moins trois zones électriquement conductrices, coplanaires, et séparées les unes des autres par des rainures parallèles disposées entre les deux électrodes.

4. Dispositif de détection bolométrique selon la revendication 1, 2 ou 3, *caractérisé* **en ce que** la membrane comporte une couche continue d'isolant électrique (52) s'étendant entre les électrodes et recouvrant partiellement chacune d'entre elles.

5. Dispositif de détection bolométrique selon l'une quelconque des revendications précédentes, *caractérisé* **en ce que** la résistivité électrique du second matériau est au moins cinq fois plus faible que la résistivité électrique du premier matériau, et de préférence dix fois à vingt fois plus faible.

6. Dispositif de détection bolométrique selon l'une quelconque des revendications précédentes, *caractérisé* **en ce que** le premier matériau a une résistivité électrique supérieure à 10 Ohm.cm, et de préférence une résistivité inférieure à $10^4$ Ohm.cm.

7. Dispositif de détection bolométrique selon l'une quelconque des revendications précédentes, *caractérisé* **en ce que** le premier matériau est du silicium amorphe, un alliage amorphe de silicium et de germanium de formule $Si_xGe_{(1-x)}$, ou un alliage amorphe de silicium et carbone de formule $a\text{-}Si_xC_{(1-x)}$, et le second matériau est un oxyde métallique.

8. Procédé de fabrication d'un dispositif de détection bolométrique, comprenant :

- la fabrication d'un substrat (60) comprenant un circuit de lecture ;
- le dépôt sur le substrat d'une couche sacrificielle (70);
- la fabrication, sur la couche sacrificielle (70), d'une matrice de membranes (12), chacune raccordée au circuit de lecture par au moins deux conducteurs électriques (66), ladite membrane comprenant deux électrodes électriquement conductrices (20, 22) respectivement raccordées aux deux conducteurs électriques, et un volume de matériau transducteur raccordant électriquement les deux électrodes ;
- une fois les membranes fabriquées, le retrait de la couche sacrificielle (70),

*caractérisé* :

- **en ce que** la fabrication du volume transducteur comporte :

■ le dépôt d'une couche inférieure d'un premier matériau transducteur (34) sur la couche sacrificielle (70) ;
■ la formation, sur la dite couche du premier matériau, des deux électrodes de la membrane (20, 22);
■ le dépôt sur, et entre les électrodes, d'une couche de second transducteur (44); et
■ l'encapsulation de la couche de second matériau transducteur (44) par une couche supérieure du premier matériau (36) de manière à également couvrir partiellement les deux électrodes,

- et **en ce que** :

■ les deux matériaux transducteurs présentent un coefficient thermique de résistivité *TCR* négatif, et la résistivité électrique du second matériau est inférieure à la résistivité électrique du premier matériau ;
■ le premier matériau est inerte au retrait de la couche sacrificielle.

9. Procédé de fabrication d'un dispositif de détection bolométrique selon la revendication 8, *caractérisé* **en ce que** la couche sacrificielle est retirée par une attaque d'acide fluorhydrique *HFv,* et **en ce que** le premier matériau est du silicium amorphe, un alliage amorphe de silicium et de germanium de formule a- $Si_xGe_{(1-x)}$, ou un alliage amorphe de silicium et carbone de formule $a\text{-}Si_xC_{(1-x)}$.

10. Procédé de fabrication d'un dispositif de détection bolométrique selon la revendication 8 ou 9, *caractérisé* **en ce que** les deux électrodes sont formés en déposant une couche de matériau électriquement conducteur et en réalisant uniquement une rainure dans ladite couche jusqu'à la couche inférieure de premier matériau.

11. Procédé de fabrication d'un dispositif de détection bolométrique selon la revendication 8 à 10, *caractérisé* **en ce que** les deux électrodes sont formés en déposant une couche de matériau électriquement conducteur et en réalisant au moins deux rainures parallèles dans ladite couche jusqu'à la couche inférieure de premier matériau.

12. Procédé de fabrication d'un dispositif de détection bolométrique selon l'une des revendications 8 à 11, *caractérisé* **en ce que** la résistivité électrique du second matériau est au moins cinq fois plus faible que la résistivité électrique du premier matériau, et de préférence dix fois à vingt fois plus faible.

13. Procédé de fabrication d'un dispositif de détection bolométrique selon l'une des revendications 8 à 12, *caractérisé* **en ce que** le premier matériau a une résistivité électrique supérieure à 10 Omh.com, et de préférence une résistivité inférieure à $10^4$ Ohm. cm.

14. Procédé de fabrication d'un dispositif de détection bolométrique selon l'une des revendications 8 à 13, *caractérisé* **en ce qu'**il comprend, avant dépôt du second matériau transducteur, le dépôt d'une couche électriquement isolante s'étendant entre les électrodes et recouvrant partiellement chacune d'entre elles.

**Patentansprüche**

1. Vorrichtung zur bolometrischen Detektion, umfassend:

   - ein Substrat (14), mit einer Ausleseschaltung,
   - eine Matrix aus elementaren Detektoren, die jeweils eine Membran (12) umfassen, die über dem Substrat gehängt ist und durch mindestens zwei elektrische (16, 18) Leiter mit der Ausleseschaltung verbunden ist, wobei diese Membran zwei elektrisch leitende Elektroden (20, 22), die jeweils mit den zwei elektrischen Leitern verbunden sind, und ein Volumen Wandlermaterials (24), das die beiden Elektroden elektrisch verbindet, aufweist,

   in dem die Ausleseschaltung konfiguriert ist, um einen elektrischen Stimulus zwischen den beiden Elektroden (20, 22) der Membran (12) anzulegen und ein elektrisches Signal als Antwort auf diese Anwendung zu bilden, **dadurch gekennzeichnet, dass**:

   - dieses Volumen:

     ▪ ein Volumen (34, 38, 40) eines ersten Wandlermaterials, das die beiden Elektroden (20, 22) der Membran (12) elektrisch verbindet und Wände eines geschlossenen Gehäuses (42) bildet, in dem jede der Elektroden (20, 22) zumindest teilweise untergebracht ist; und
     ▪ ein Volumen (44) eines zweiten Wandlermaterials, das die beiden Elektroden (20, 22) elektrisch verbindet und in dem Gehäuse (42) untergebracht ist, wobei der spezifische elektrische Widerstand des zweiten Materials kleiner als der spezifische elektrische Widerstand des ersten Materials ist, umfasst;

   - und dadurch dass die beiden Wandlermaterialien einen negativen spezifischen thermischen Widerstandskoeffizienten TCR haben.

2. Vorrichtung zur bolometrischen Detektion nach Anspruch 1, **dadurch gekennzeichnet, dass** die beiden Elektroden (20, 22) koplanar sind und nur durch eine Rille getrennt sind.

3. Vorrichtung zur bolometrischen Detektion nach Anspruch 1, **dadurch gekennzeichnet, dass** die beiden Elektroden (20, 22) zu einer Reihe von mindestens drei elektrisch leitenden, koplanaren und voneinander durch parallel zwischen den beiden Elektroden angeordnete Rillen getrennten Zonen gehören.

4. Vorrichtung zur bolometrischen Detektion nach einem der Ansprüche 1, 2 oder 3, **dadurch gekennzeichnet, dass** die Membran eine durchgehende Schicht eines elektrisch isolierenden Materials (52) enthält, die zwischen den Elektroden verläuft und jede einzelne teilweise bedeckt.

5. Vorrichtung zur bolometrischen Detektion nach einem der Ansprüche 1, 2 oder 3, **dadurch gekennzeichnet, dass** der spezifische elektrische Widerstand des zweiten Materials mindestens fünf Mal niedriger ist, als der spezifische elektrische Widerstand des ersten Materials und noch besser zehn bis zwanzig Mal niedriger.

6. Vorrichtung zur bolometrischen Detektion nach einem der vorstehenden Ansprüche, **dadurch gekennzeichnet, dass** das erste Material einen spezifischen elektrischen Widerstand von mehr als 10 Ohm.cm und besser noch einen spezifischen elektrischen Widerstand von unter 104 Ohm.cm hat.

7. Vorrichtung zur bolometrischen Detektion nach einem der vorstehenden Ansprüche, **dadurch gekennzeichnet, dass** das erste Material amorphes Silizium ist, eine amorphe Legierung aus Silizium und Germanium mit der Formel $Si_xGe_{(1-x)}$, oder eine amorphe Legierung aus Silizium und Kohlenstoff mit der Formel $\alpha\text{-}Si_xC_{(1-x)}$, und das zweite Material ein Metalloxid ist.

8. Verfahren zur Herstellung einer bolometrischen Detektionsvorrichtung, umfassend:

   - die Herstellung eines Substrats (60) mit einer Ausleseschaltung,
   - die Ablagerung auf dem Substrat einer Opferschicht (70);
   - die Bildung, auf der Opferschicht (70), einer Membranmatrix (12), die jeweils über mindestens zwei elektrische Leiter mit der Ausleseschaltung (66) verbunden ist, wobei diese Membran zwei elektrisch leitende Elektroden (20, 22), die jeweils mit den zwei elektrischen Leitern verbunden sind, und ein Volumen Wandlermaterials, das die beiden Elektroden elektrisch verbindet, umfasst;
   - sobald die Membrane hergestellt sind, die Entfernung der Opferschicht (70), **dadurch gekennzeichnet, dass**
   - die Herstellung des Wandlervolumens umfasst:

     ■ die Ablagerung einer unteren Schicht eines ersten Wandlermaterials (34) auf der Opferschicht (70)
     ■ die Bildung auf dieser Schicht ersten Materials, der beiden Elektroden (20, 22);
     ■ die Ablagerung auf und zwischen den Elektroden einer Schicht eines zweiten Wandlers (44); und
     ■ die Einkapselung der Schicht des zweiten Wandlermaterials (44) durch eine obere Schicht des ersten Materials (36), so dass auch die beiden Elektroden teilweise bedeckt sind,

   - und dadurch dass:

     ■ die beiden Wandlermaterialien einen negativen Temperaturkoeffizienten des spezifischen Widerstandes TCR aufweisen und der spezifische elektrische Widerstand des zweiten Materials kleiner ist, als der spezifische elektrische Widerstand des ersten Materials;
     ■ das erste Material gegenüber der Entfernung der Opferschicht inert ist.

9. Verfahren zur Herstellung einer bolometrischen Detektionsvorrichtung nach Anspruch 8, **dadurch gekennzeichnet, dass** die Opferschicht durch einen Angriff mit Flusssäure HFv, entfernt wird und dass es sich bei dem ersten Material um amorphes Silizium, eine amorphe Legierung aus Silizium und Germanium mit der Formel $a\text{-}Si_xGe_{(1-x)}$ oder eine amorphe Legierung aus Silizium und Kohlenstoff mit der Formel $\alpha\text{-}Si_xC_{(1-x)}$ handelt.

10. Verfahren zur Herstellung einer bolometrischen Detektionsvorrichtung nach Anspruch 8 oder 9, **dadurch gekennzeichnet, dass** die beiden Elektroden durch Ablagerung einer Schicht aus elektrisch leitendem Material und durch Ausführung nur einer Rille in dieser Schicht, bis zur unteren Schicht aus dem ersten Material erfolgt.

11. Verfahren zur Herstellung einer bolometrischen Detektionsvorrichtung nach Anspruch 8 bis 10, **dadurch gekennzeichnet, dass** die beiden Elektroden durch Ablagerung einer Schicht elektrisch leitenden Materials und durch Ausführung mindestens zwei paralleler Rillen in dieser Schicht bis zur unteren Schicht aus dem ersten Material gebildet werden.

12. Verfahren zur Herstellung einer bolometrischen Detektionsvorrichtung nach einem der Ansprüche 8 bis 11, **dadurch**

**gekennzeichnet, dass** der spezifische elektrische Widerstand des zweiten Materials mindestens fünf Mal niedriger ist, als der spezifische elektrische Widerstand des ersten Materials und noch besser zehn bis zwanzig Mal niedriger.

13. Verfahren zur Herstellung einer bolometrischen Detektionsvorrichtung nach einem der Ansprüche 8 bis 12, **dadurch gekennzeichnet, dass** das erste Material einen spezifischen elektrischen Widerstand von mehr als 10 Ohm.cm und besser noch einen spezifischen Widerstand von unter 104 Ohm.cm hat.

14. Verfahren zur Herstellung einer bolometrischen Detektionsvorrichtung nach einem der Ansprüche 8 bis 13, **dadurch gekennzeichnet, dass** es, vor Ablagerung des zweiten Wandlermaterials eine elektrisch isolierende Schicht umfasst, die zwischen den Elektroden verläuft und jede von ihnen teilweise bedeckt.


**Claims**

1. A bolometric detection device comprising:

    - a substrate (14) comprising a read-out circuit;
    - an array of elementary detectors each comprising a membrane (12) suspended above the substrate (14) and connected to the read-out integrated circuit by at least two electric conductors (16, 18), said membrane comprising two electrically-conductive electrodes (20, 22) respectively connected to the two electric conductors, and a volume of transducer material (24) electrically connecting the two electrodes,

    wherein the read-out circuit is configured to apply an electrical stimulus between the two electrodes (20, 22) of the membrane (12) and to form an electric signal as a response to said application, **characterized:**

    - **in that** said volume comprises:

        ▪ a volume (34, 38, 40) of a first transducer material electrically connecting the two electrodes (20, 22) of the membrane (12) and forming walls of a closed enclosure (42) having each of the electrodes (20, 22) at least partially housed therein; and
        ▪ a volume (44) of a second transducer material, electrically connecting the two electrodes (20, 22) and housed in the enclosure (42), the electric resistivity of the second material being smaller than the electric resistivity of the first material;

    - and **in that** the two transducer materials have a negative thermal coefficient of resistivity *TCR.*

2. The bolometric detection device of claim 1, ***characterized* in that** the two electrodes (20, 22) are coplanar and only separated by one groove.

3. The bolometric detection device of claim 1, ***characterized* in that** the two electrodes (20, 22) belong to a series of at least three electrically-conductive coplanar areas, separated from one another by parallel grooves arranged between the two electrodes.

4. The bolometric detection device of claim 1, 2, or 3, ***characterized* in that** the membrane comprises a continuous electric insulator layer (52) extending between the electrodes and partially covering each of them.

5. The bolometric detection device of any of the foregoing claims, ***characterized* in that** the electric resistivity of the second material is at least five times smaller than the electric resistivity of the first material and preferably from ten times to twenty times smaller.

6. The bolometric detection device of any of the foregoing claims, ***characterized* in that** the first material has an electric resistivity greater than 10 Ohm.cm, and preferably a resistivity smaller than $10^4$ Ohm.cm.

7. The bolometric detection device of any of the foregoing claims, ***characterized* in that** the first material is amorphous silicon, an amorphous alloy of silicon and germanium of formula $Si_xGe_{(1-x)}$, or an amorphous alloy of silicon and carbon of formula $a\text{-}Si_xC_{(1-x)}$, and the second material is a metal oxide.

8. A method of manufacturing a bolometric detection device, comprising:

  - manufacturing a substrate (60) comprising a read-out circuit;
  - depositing a sacrificial layer (70) on the substrate;
  - manufacturing, on the sacrificial layer (70), an array of membranes (12), each connected to the read-out circuit by at least two electric conductors (66), said membrane comprising two electrically-conductive electrodes (20, 22) respectively connected to the two electric conductors, and a volume of transducer material electrically connecting the two electrodes;
  - once the membranes have been manufactured, removing the sacrificial layer (70),

  **characterized:**

  - **in that** the manufacturing of the transducer volume comprises:

    ▪ depositing a lower layer of a first transducer material (34) on the sacrificial layer (70);
    ▪ forming, on said layer of the first material, the two membrane electrodes (20, 22);
    ▪ depositing on and between the electrodes a layer of second transducer (44); and
    ▪ encapsulating the layer of second transducer material (44) with an upper layer of the first material (36) to also partially cover the two electrodes,

  - and **in that**:

    ▪ the two transducer materials have a negative thermal coefficient of resistivity *TCR,* and the electric resistivity of the second material is smaller than the electric resistivity of the first material;
    ▪ the first material is inert to the removal of the sacrificial layer.

9. The bolometric detection device manufacturing method of claim 8, ***characterized* in that** the sacrificial layer is removed by a *HFv* hydrofluoric acid etching, and **in that** the first material is amorphous silicon, an amorphous alloy of silicon and germanium of formula $a\text{-}Si_xGe_{(1-x)}$, or an amorphous alloy of silicon and carbon of formula $a\text{-}Si_xC_{(1-x)}$.

10. The bolometric detection device manufacturing method of claim 8 or 9, ***characterized* in that** the two electrodes are formed by depositing a layer of electrically-conductive material and by only forming one groove in said layer down to the lower layer of first material.

11. The bolometric detection device manufacturing method of claim 8 or 10, ***characterized* in that** the two electrodes are formed by depositing a layer of electrically-conductive material and by forming two parallel grooves in said layer down to the lower layer of first material.

12. The bolometric detection device manufacturing method of any of claims 8 to 11, ***characterized* in that** the electric resistivity of the second material is at least five times smaller than the electric resistivity of the first material and preferably from ten times to twenty times smaller.

13. The bolometric detection device manufacturing method of any of claims 8 to 12, ***characterized* in that** the first material has an electric resistivity greater than 10 Ohm.cm, and preferably a resistivity smaller than $10^4$ Ohm.cm.

14. The bolometric detection device manufacturing method of any of claims 8 to 13, ***characterized* in that** it comprises, before depositing the second transducer material, depositing an electrically-insulating layer extending between the electrodes and partially covering each of them.

**Fig. 1**

(Etat de la technique)

(Etat de la technique)

**Fig. 2**

Vpol

(Etat de la technique)

**Fig. 3**

(Etat de la technique)

## Fig. 4

## Fig. 5

## Fig. 6

**Fig. 7**

**Fig. 8**

**Fig. 9**

**Fig. 10**

Legend:
- ◆ Transducteur a-Si 200nm
- — Transducteur mixte a-Si 2x20nm + Mox 40nm - 1 rainure
- △ Transducteur mixte a-Si 2x20nm + Mox 40nm - 2 rainures
  Rb transducteur a-Si
- ◇ Rb (a-Si +Mox),1 rainure
- □ Rb (a-Si +Mox),2 rainures

**Fig. 11**

**Fig. 12**

**Fig. 13**

54 | L' | 56

W

XV | XV

L | L

**Fig. 14**

44 | 36

54 20 | 34 50 | 52 22 | 56

**Fig. 15**

**Fig. 16**

**Fig. 17**

**EP 3 182 081 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5912464 A
- US 2014319350 A
- EP 2894444 A
- EP 2908109 A
- JP 2000346704 B
- US 5288649 A
- US 20060060784 A
- US 20090140148 A

**Littérature non-brevet citée dans la description**

- **E. MOTTIN et al.** *Infrared Technology and Application,* vol. 4820E